# DEMANDE DE BREVET EUROPEEN

(11) **EP 2 654 083 A1**
(43) Date de publication de la demande: **23.10.2013**
(21) Numéro de dépôt: 13163838.9
(22) Date de dépôt: 16.04.2013
(51) Int. Cl.: H01L 29/10, H01L 29/417, H01L 29/775, H01L 29/06, H01L 29/66, H01L 29/41, B82Y 40/00, B82Y 10/00

(54) **Procédé ameliore de réalisation d'une structure de transistor a nano-fils superposes et a grille enrobante**

(30) Priorité: 16.04.2012 FR 1253490
(71) Demandeur: Commissariat à l'Énergie Atomique et aux Énergies Alternatives, 75015 Paris (FR)
(72) Inventeur: Vinet, Maud, 38140 RIVES SUR FURE (FR); Barraud, Sylvain, 38690 LE GRAND LEMPS (FR); Grenouillet, Laurent, 38140 RIVES (FR)
(74) Mandataire: Ilgart, Jean-Christophe

(57) **Abrégé**

La présente invention concerne un procédé de réalisation d'un dispositif microélectronique comprenant doté d'une structure de canal formée de nano-fils superposés, dans lequel on forme tout d'abord un empilement de nano-fils ayant une section transversale constante, puis une grille sacrificielle et des espaceurs isolants, la formation de zones de source et de drain étant effectuée ensuite par croissance de matériau semi-conducteur sur les zones de l'empilement qui ne sont pas protégées par la grille sacrificielle et les espaceurs isolants (Figure 4D).

## Description

### DOMAINE TECHNIQUE

La présente invention se rapporte au domaine la micro-électronique, et plus particulièrement à celui des transistors, et concerne la réalisation d'au moins un transistor doté d'une structure semi-conductrice de canal sous forme d'une pluralité de nano-fils et d'une grille enrobante autour des nano-fils, et dont l'encombrement est réduit.

### ART ANTÉRIEUR

La réalisation d'un transistor dont la structure de canal est formée d'une pluralité de nano-fils est connue.

Le document WO 2010/090978 divulgue par exemple un procédé de réalisation d'un tel type de transistor doté d'une structure de canal à nano-fils juxtaposés reliant une zone de source et de drain.

La réalisation d'un transistor doté d'une structure de canal à nano-fils superposés reliant une zone de source et de drain est également connue.

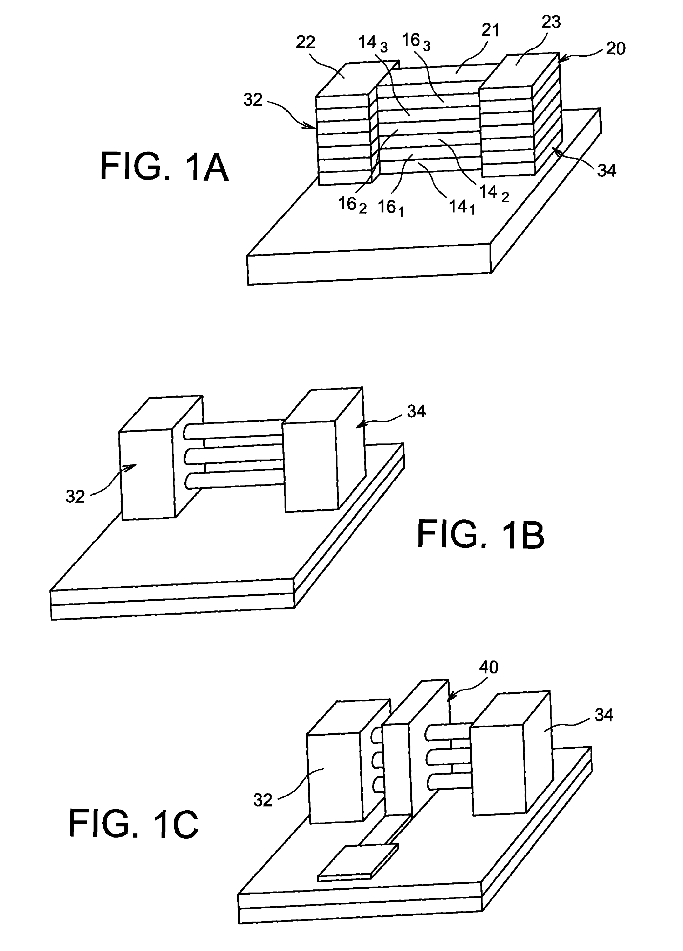

Un procédé de fabrication d'un tel transistor peut comprendre la formation d'un empilement de couches semi conductrices comprenant une alternance de couches à base de Si et de couches à base de SiGe, que l'on grave à travers un masque dur 20. Ce masque dur 20 peut être formé d'un motif 21 de forme allongée reliant entre eux deux autres motifs 22, 23 de largeur plus importante. On effectue ensuite une gravure à travers le masque dur 20 afin de former des nano-fils 14₁, 16₁, 14₂, 16₂, 14₃, 16₃ superposés sous le motif 21 de forme allongée et des blocs 32, 34 de largeur plus importante que celle des nano-fils sous les autres motifs 22, 23. Les blocs 32, 34 de largeur plus importante sont destinés à former des zones de source et de drain, reliées entre elles par un canal formé d'un empilement de nano-fils 14₁, 16₁, 14₂, 16₂, 14₃, 16₃ superposés (figure 1A).

Puis, on effectue notamment un retrait sélectif du SiGe par rapport au Si, de manière à libérer les nano-fils de Si 14₁, 14₂, 14₃, (figure 1B).

Le document WO 2008/069765 A1 présente par exemple un tel type de procédé.

Ensuite, on réalise une grille 40 sur les nano-fils de Si entre les blocs de source 32 et de drain 34, par dépôt de matériau de grille puis gravure (figure 1C).

Avec un tel procédé, pour permettre de libérer les nano-fils de Si tout en permettant un maintien de la structure, des règles de dessin contraignantes doivent être appliquées pour définir les motifs du masque dur 20 et par conséquent les éléments 32, 34, 14₁, 16₁, 14₂, 16₂, 14₃, 16₃ Du fait de ces règles de dessin, l'encombrement des blocs de source et de drain 32, 34 est important.

Avec un tel procédé, un bon positionnement ainsi qu'une bonne définition du motif de grille s'avèrent difficiles à obtenir.

Pour résoudre le problème de positionnement de la grille et limiter les effets d'une éventuelle asymétrie de positionnement des blocs de source et de drain par rapport à la grille, on peut avoir tendance à vouloir augmenter la longueur des nano-fils et éloigner davantage entre eux les blocs de source et de drain.

Lorsque les nano-fils sont libérés par gravure, un éloignement important des nano-fils peut cependant engendrer, un phénomène de flambage des nano-fils, de perte de contrainte lorsque ces nano-fils sont à base d'un matériau semi-conducteur contraint, et de défaut d'uniformité de la section transversale des nano-fils située sous la grille enrobante.

Le document US 2011/0281412A1 présente une autre méthode de réalisation de transistor à structure de canal sous forme de nano-fils et doté d'une grille enrobante autour des nano-fils, cette grille étant formée par procédé de type Damascène.

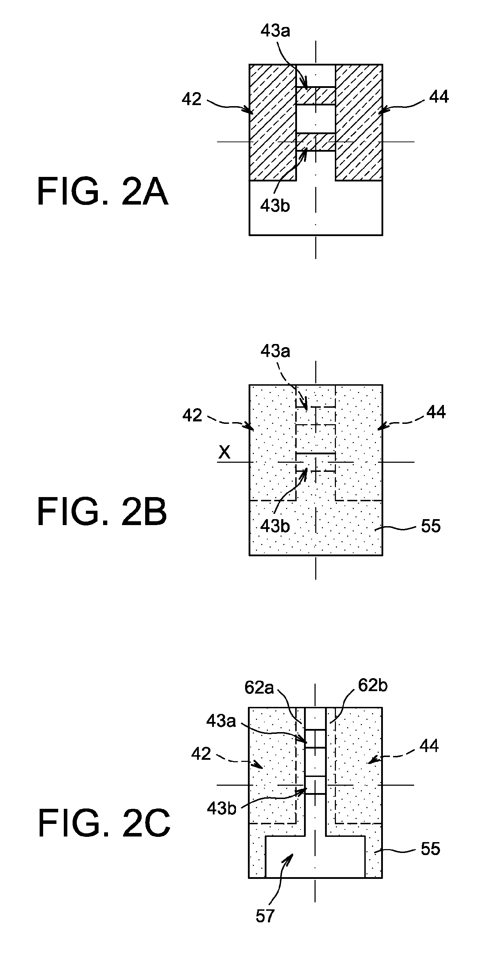

Dans un tel procédé, on réalise dans un empilement de couches semi-conductrices comprenant une alternance de couches à base de Si et de couches à base de SiGe, une structure comprenant des empilements 43a, 43b de nano-fils reliant un bloc semi-conducteur 42 de source et un bloc semi-conducteur 44 de drain (figure 2A).

On recouvre ensuite la structure d'une couche isolante 55 (figure 2B).

Puis, on forme dans cette couche isolante 55 une ouverture 57 ayant la forme d'un motif de grille. L'ouverture 57 est réalisée de manière à conserver des espaceurs isolants 62a, 62b contre les blocs de source 42, et de drain 44 (figure 2C).

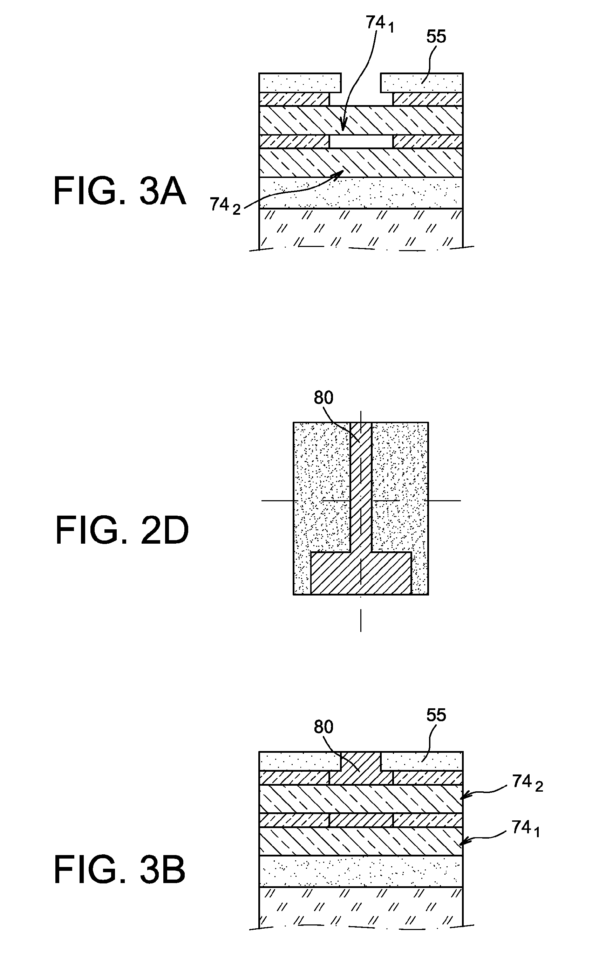

La couche isolante 55 est quant à elle retirée des empilements de nanofils pour permettre d'effectuer un retrait sélectif du SiGe par rapport au Si et ainsi libérer les nano-fils de Si 74₁, 74₂, (figure 3A illustrant la structure selon une coupe transversale).

Ensuite, on forme la grille 80 par remplissage de l'ouverture 57 d'un empilement de grille (figure 2D, et figure 3B illustrant la structure selon une coupe transversale).

Avec un tel procédé, on forme des espaceurs isolants entre la grille et les blocs de source et de drain, tout en permettant une définition du motif de grille plus aisée, ainsi qu'un meilleur positionnement de la grille par rapport à l'exemple de procédé précédemment décrit.

Cependant comme dans l'exemple de procédé précédemment décrit, pour permettre de libérer les nano-fils de Si tout en permettant un maintien de la structure, des règles contraignantes de dessin sont nécessaires, ce qui implique une taille minimum des blocs de source et de drain.

Par ailleurs, avec un tel procédé la longueur de grille 80 n'est pas uniforme.

Avec un tel procédé, la longueur de la grille 80 est définie par la distance initiale entre les blocs 42, 44 de source et drain, cette distance étant elle même dépendantes de règles de dessin concernant la taille des blocs de source et de drain et la largeur des nano-fils, ce qui empêche de réaliser des grilles de faible longueur, et en particulier de longueur inférieure à 25 nm.

Le document US°2006/0216897°A1 présente un procédé de réalisation d'un transistor doté d'une structure semi-conductrice de canal à nano-fils, formés par une première gravure d'un empilement de couches à base de matériaux semi-conducteurs différents, puis une gravure sélective afin de réaliser une structure de canal sous forme d'une pluralité de nano-fils.

Avec un tel procédé, après la première gravure et préalablement à la gravure sélective, une étape de gravure supplémentaire de l'empilement est nécessaire afin de réduire la dimension critique des nanofils. Par ailleurs, un tel procédé est contraignant en matière de règles de dessins.

Il se pose le problème de trouver un procédé amélioré de réalisation d'un transistor doté d'une structure semi-conductrice de canal sous forme d'une pluralité de nano-fils et d'une grille enrobante autour des nano-fils, dont l'encombrement est réduit tout en ayant un nombre d'étapes limité et permettant de suivre des règles de dessins moins contraignantes.

### EXPOSÉ DE L'INVENTION

La présente invention concerne tout d'abord un procédé de réalisation d'un dispositif microélectronique comprenant un transistor doté d'une structure semi-conductrice formée de nano-fils, le procédé comprenant les étapes de :
a) réalisation sur un support, d'un empilement ou de plusieurs empilements juxtaposés de nano-fils superposés, le ou les empilements ayant une section transversale constante et étant formés d'une alternance de nano-fils à base d'au moins un premier matériau semi-conducteur, et de nano-fils à base d'au moins un deuxième matériau semi-conducteur,
b) formation d'une grille sacrificielle sur, et contre des flancs latéraux de, au moins une zone centrale d'au moins un ou plusieurs desdits empilements de nanofils,
c) formation de zones isolantes contre des flancs latéraux de ladite grille sacrificielle, de manière à couvrir des zones desdits flancs latéraux desdits empilements de part et d'autre de ladite zone centrale desdits empilements,
d) formation de zones semi-conductrices sur des zones d'extrémités d'au moins un desdits empilement par croissance d'au moins un matériau semi-conducteur.

A l'étape a), les empilements sont réalisés avec une section transversale constante de sorte que les zones d'extrémités des empilements ont une section égale à celle de la zone centrale de ces empilements.

A l'issue de l'étape a), les nano-fils ont une dimension critique dc qui peut être ensuite conservée tout au long du procédé sans qu'une étape de réduction de cette dimension critique soit nécessaire.

Le procédé suivant l'invention permet ainsi de suivre des règles de dessin moins strictes que les procédés de réalisation de nanofils suivant l'art antérieur.

Le procédé suivant l'invention est particulièrement avantageux dans le cas où à l'étape a), on forme plusieurs empilements de nano-fils juxtaposés dans la mesure où en prévoyant de mettre en oeuvre plusieurs empilements juxtaposés de section transversale constante, il permet d'obtenir une densité d'intégration de nano-fils accrue.

A l'étape d), après avoir réalisé une grille sacrificielle et des espaceurs isolants sur la zone centrale des empilements, on augmente les dimensions de zones d'extrémités des empilements qui sont dévoilées, et en particulier ne sont recouvertes ni par les zones isolantes ni par la grille sacrificielle pour réaliser des blocs de source et de drain de transistor.

On limite ainsi l'encombrement final des blocs de source et de drain.

Avec un tel procédé, on limite également les contraintes de règles de dessin relatives à la surface occupée par les blocs de source et de drain sur le support et à l'écartement des blocs de source et de drain, notamment par rapport aux procédés dans lesquels les blocs de source et de drain sont réalisés par gravure en même temps que la structure semi-conductrice les reliant.

En formant les zones de source et de drain après l'empilement de nanofils, on limite également les contraintes de règles de dessin relatives à l'écartement des transistors entre eux. On peut ainsi réaliser des transistors davantage rapprochés et augmenter la densité d'intégration des transistors sur un substrat.

A l'étape a), la formation des empilements de nano-fils peut comprendre la gravure, à travers un masque dur d'un empilement de couches formé d'une alternance de couches à base du premier matériau semi-conducteur et de couches à base du deuxième matériau semi-conducteur.

Selon une possibilité de mise en oeuvre, le ou les empilements de nanofils peuvent être recouverts du masque dur à l'étape d).

Ainsi, ce masque dur peut permettre de former l'empilement de nanofils par gravure à l'étape a) et empêcher une croissance de matériau semi-conducteur sur le dessus de cet empilement à l'étape d).

Selon une possibilité de mise en oeuvre, le masque dur peut avoir une section transversale constante.

Le procédé peut comprendre en outre, après l'étape d), des étapes de :
- formation sur ledit support d'une couche de masquage recouvrant ledit ou lesdits empilements et la grille sacrificielle,
- formation d'une ouverture dans la couche de masquage comprenant la gravure de la grille sacrificielle de manière à dévoiler ladite zone centrale dudit ou desdits empilements de nano-fils.

On permet ainsi un accès à la zone centrale du ou des empilements de nano-fils tout en protégeant le reste de cet ou de ces empilements.

L'ouverture peut avoir une dimension critique égale ou sensiblement égale à la longueur de la grille sacrificielle. Par sensiblement égale on entend ici qui diffère de moins de 5 nanomètres.

Les dimensions de l'ouverture sont ainsi prévues en fonction de celles de la grille sacrificielle. Un remplissage ultérieur de l'ouverture par la grille sacrificielle peut ensuite permettre de réaliser une grille de dimensions égales ou sensiblement égales à celle de la grille sacrificielle.

La grille sacrificielle peut être formée à l'étape b) par gravure d'un empilement de grille au travers d'un autre masque dur, la formation de ladite ouverture dans la couche de masquage comprenant la gravure sélective dudit autre masque dur préalablement à la gravure de la grille sacrificielle.

Ainsi, l'autre masque dur peut être prévu à base d'un matériau susceptible d'être gravé de manière sélective vis-à-vis de celui de la couche de masquage.

Cet autre masque dur peut avoir une dimension critique égale ou sensiblement égale à la longueur de la grille sacrificielle.

Le procédé peut comprendre en outre, après formation de la couche de masquage et préalablement à la formation de ladite ouverture, une étape de retrait de la couche de masquage jusqu'à atteindre ledit autre masque dur.

Ainsi, on peut former l'ouverture en effectuant tout d'abord une gravure sélective de l'autre masque dur et sans devoir effectuer une étape de photolithographie.

Le procédé peut comprendre en outre, le retrait sélectif dans ladite ouverture du deuxième matériau semi-conducteur vis-à-vis du premier matériau semi-conducteur.

On libère ainsi des portions des nano-fils à base du premier matériau semi-conducteur situées dans l'ouverture, ces portions pouvant être ensuite recouvertes d'une grille, sans que le reste de l'empilement ne soit altéré.

Après ce retrait sélectif du deuxième matériau semi-conducteur vis-à-vis du premier matériau semi-conducteur, on peut former une grille dans ladite ouverture.

On peut ainsi obtenir une grille dont les dimensions et le positionnement dépendent des dimensions et du positionnement de l'ouverture, les dimensions et le positionnement de l'ouverture dépendant quant à elles des dimensions et du positionnement de l'autre masque dur ayant permis de réaliser la grille sacrificielle.

La grille peut être avantageusement formée dans ladite ouverture sur et autour des nanofils de même dimension critique dc qu'à l'issue de l'étape a) de formation du ou des empilements de section transversale constante.

Dans ce cas, à l'issue de l'étape a), les nano-fils ont une dimension critique dc qui est conservée tout au long du procédé sans qu'une étape de gravure supplémentaire des nano-fils soit réalisée.

Or toute réduction de dimension en cours de procédé de fabrication risque de conduire à la formation de capacités parasites additionnelles.

Cela permet également de mettre en oeuvre une densité d'intégration importante.

Ainsi, les nano-fils peuvent être prévus avec une dimension critique faible dès l'étape a) sans qu'une étape de réduction supplémentaire de leur dimension critique soit nécessaire.

Selon une possibilité de mise en oeuvre du procédé dans lequel l'étape b) comprend la formation d'une grille sacrificielle sur un ou plusieurs empilements parmi les desdits empilements, et la formation d'une autre grille sacrificielle sur un ou plusieurs autres empilements parmi lesdits autres empilements, et dans lequel une autre ouverture est réalisée dans ladite couche de masquage recouvrant lesdits empilements, le procédé peut comprendre en outre le retrait de ladite autre grille sacrificielle à travers ladite autre ouverture, puis le retrait sélectif du premier matériau semi-conducteur vis-à-vis du deuxième matériau semi-conducteur dans la dite autre ouverture.

Ainsi, sur un même support, on peut réaliser un transistor doté d'une structure de canal formé d'une pluralité de nano-fils à base du premier matériau semi-conducteur et d'une grille enrobante, et un transistor doté d'une pluralité de nano-fils à base du deuxième matériau semi-conducteur et d'une grille enrobante.

Selon une possibilité de mise en oeuvre, à l'étape d) ou entre l'étape c) et l'étape d), on peut former des zones semi-conductrices ayant un profil dentelé.

Un profil dentelé pour les zones de source et de drain peut permettre de réaliser sur les zones de source et de drain des zones de contact améliorées, par exemple à base d'alliage de matériau semi-conducteur et de métal.

La présente invention prévoit également un dispositif microélectronique comprenant :
- une structure de canal de transistor formée de nano-fils superposés à base d'un premier matériau semi-conducteur, la structure de canal reliant un premier bloc semi-conducteur comprenant une zone de source dudit transistor et un deuxième bloc semi-conducteur comprenant une zone de drain dudit transistor,
   le premier bloc semi-conducteur et le deuxième bloc semi-conducteur étant formés sur un support d'un empilement comprenant des portions desdits nano-fils à base du premier matériau semi-conducteur répartis en alternance avec des portions de nano-fils à base d'un deuxième matériau semi-conducteur,
- une grille enrobant une portion centrale desdits nano-fils à base du premier matériau semi-conducteur de ladite structure de canal,
- des premiers espaceurs isolants disposés sur le support contre des flancs latéraux de ladite grille et couvrant des zones latérales du premier bloc semi-conducteur,
- des seconds espaceurs isolants disposés sur le support contre des flancs latéraux de ladite grille et couvrant des zones latérales du deuxième bloc semi-conducteur,
la grille ayant une dimension critique constante dans un plan de section transversal à la direction d'allongement des nano-fils.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1C, illustrent un exemple de procédé, suivant l'art antérieur, de réalisation d'une structure de canal de transistor à nano-fils superposés et à grille enrobante,
- les figures 2A à 2D, et 3A à 3B, illustrent un autre exemple de procédé, suivant l'art antérieur, de réalisation d'une structure de canal de transistor à nano-fils superposés et à grille enrobante, des espaceurs isolants étant prévus contre la grille,
- les figures 4A à 4F, 5A à 5H, 6A à 6H, 7A à 7H, et 8B à 8H, illustrent un exemple de procédé microélectronique, selon l'invention, comprenant la réalisation d'une structure de transistor à nano-fils superposés et à grille enrobante de côte uniforme,
- les figures 9A et 9B, illustrent un exemple de procédé microélectronique, selon l'invention, permettant la réalisation, sur un même support, d'une structure de transistor NMOS à nano-fils superposés et à grille enrobante et d'une structure de transistor PMOS à nano-fils superposés et grille à enrobante.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

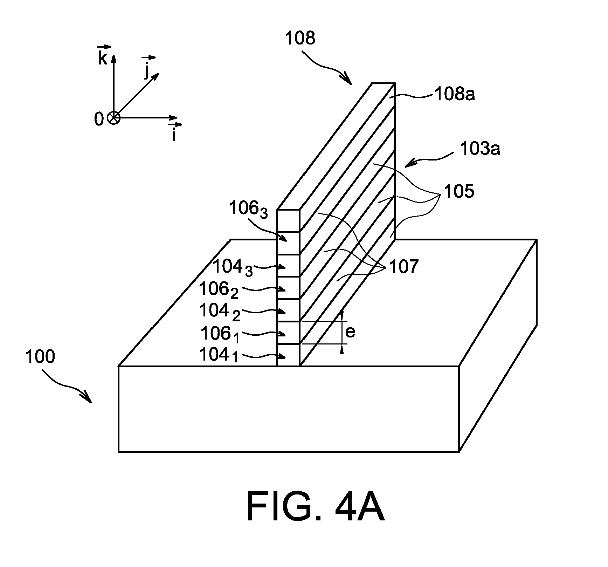

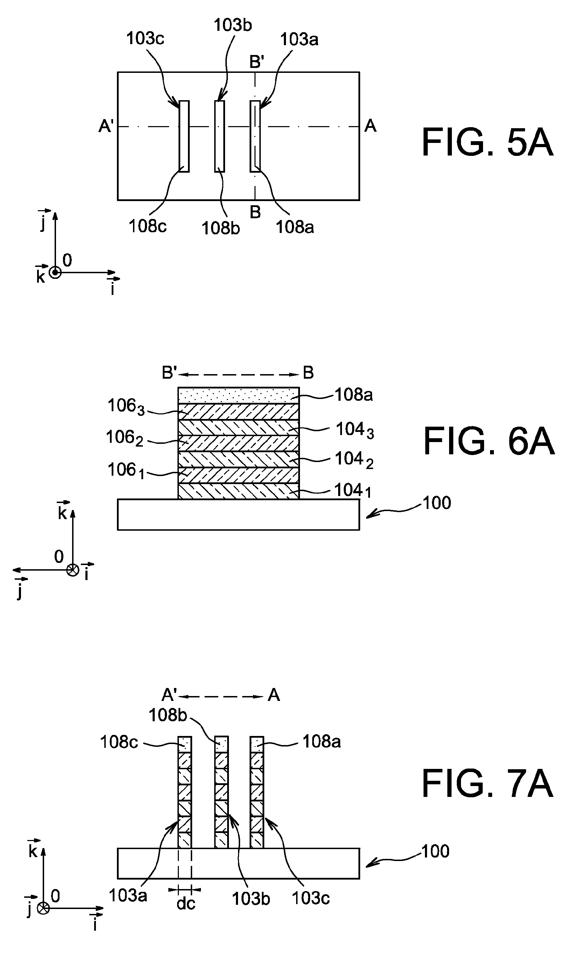

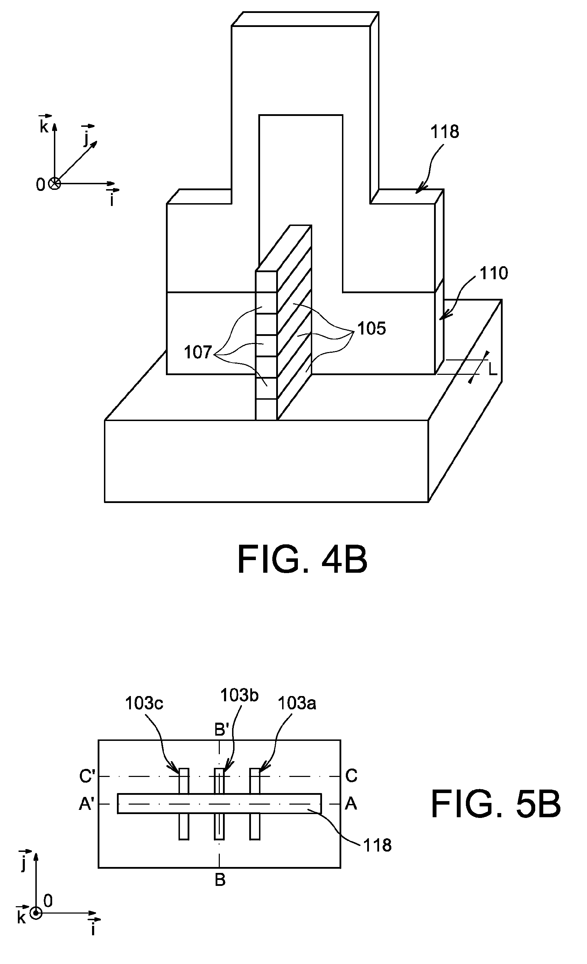

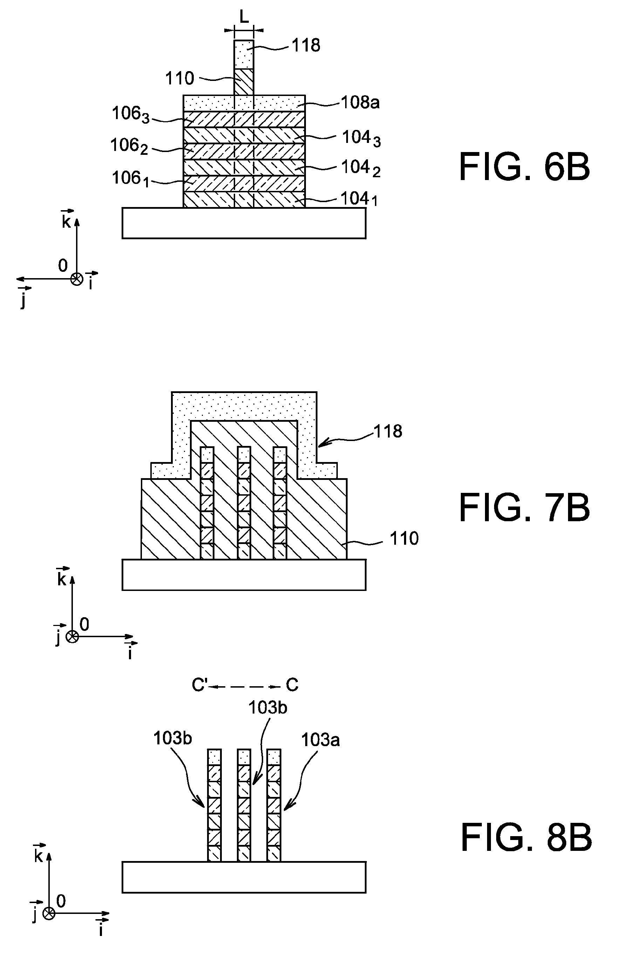

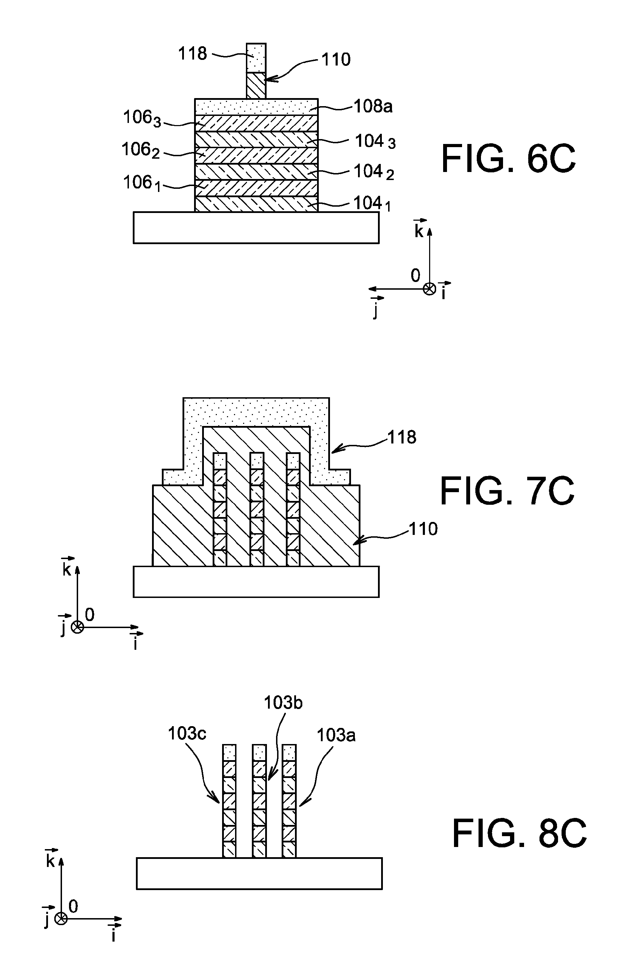

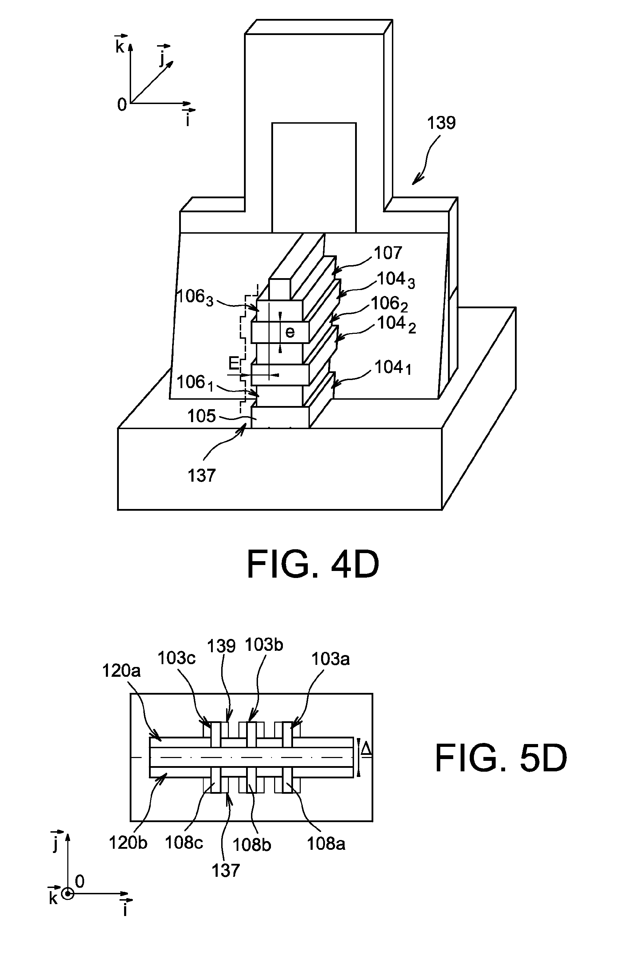

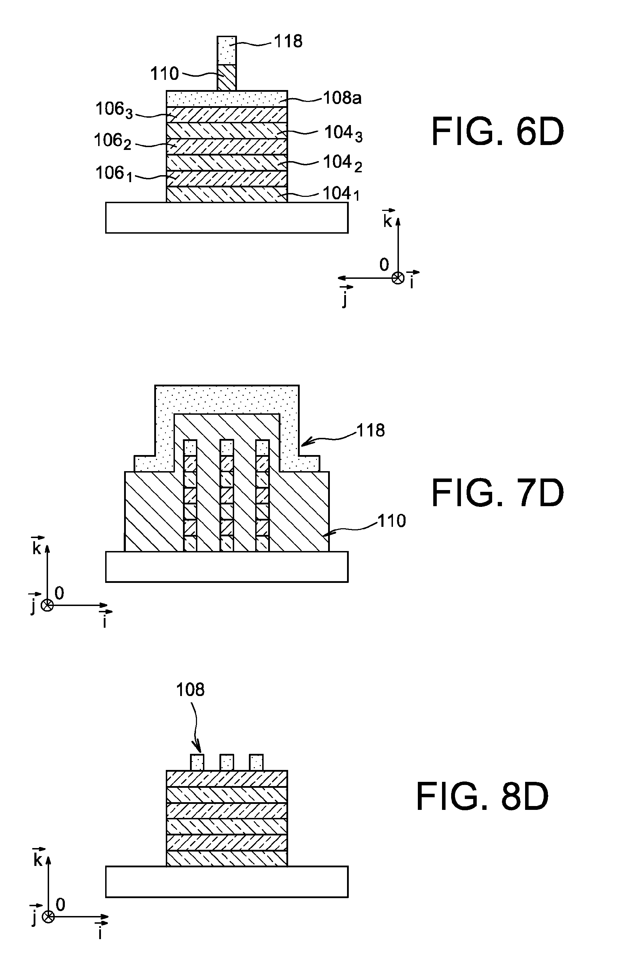

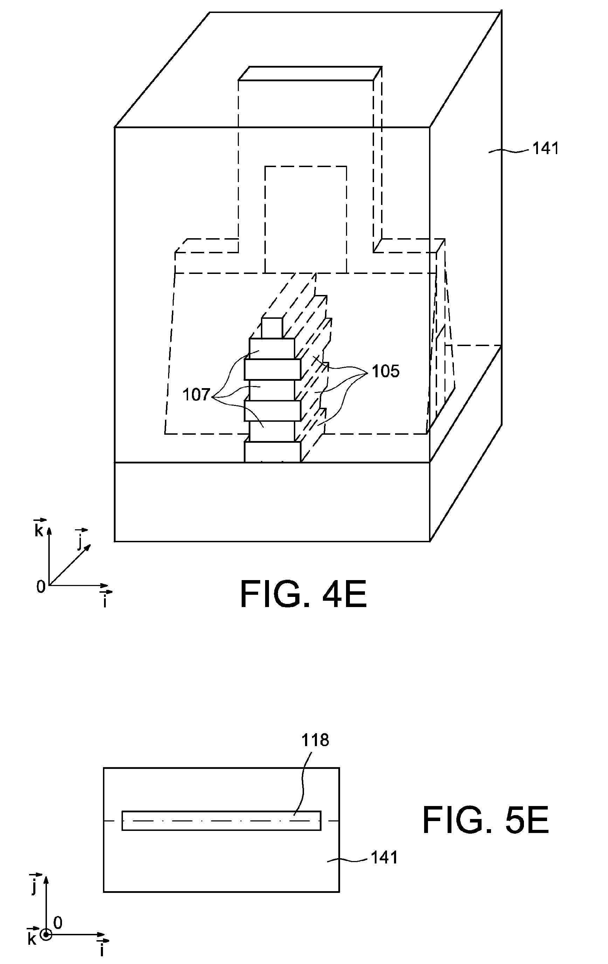

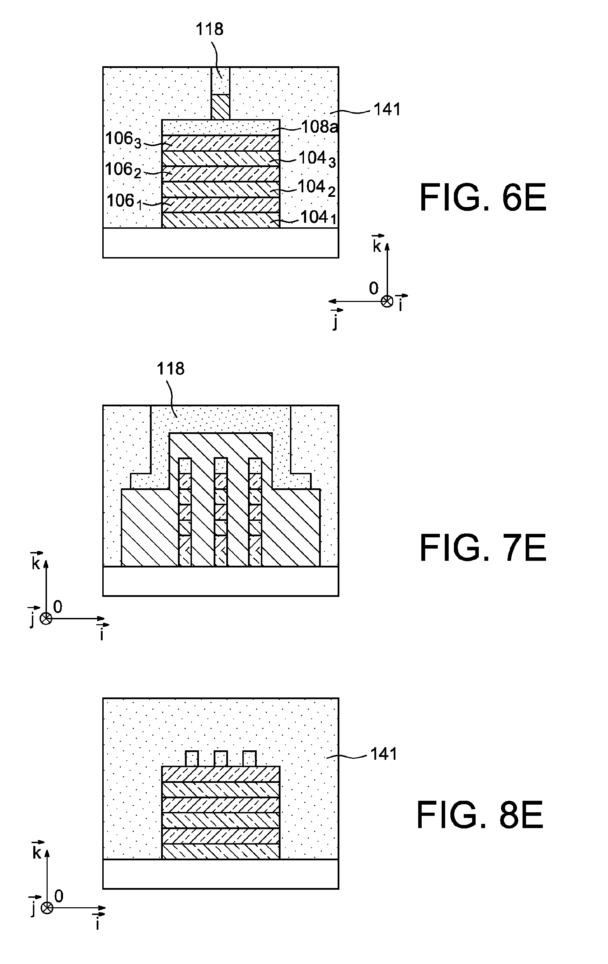

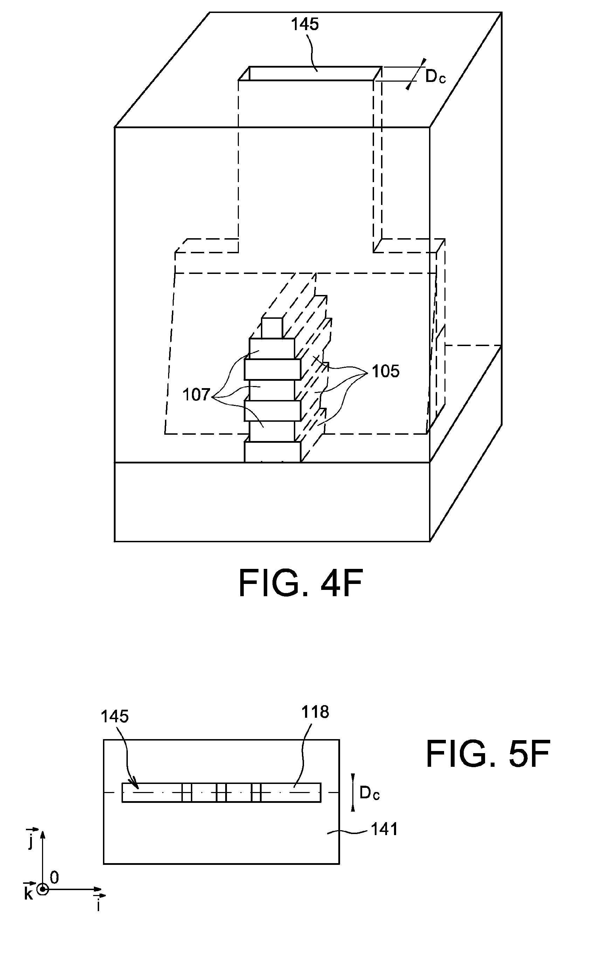

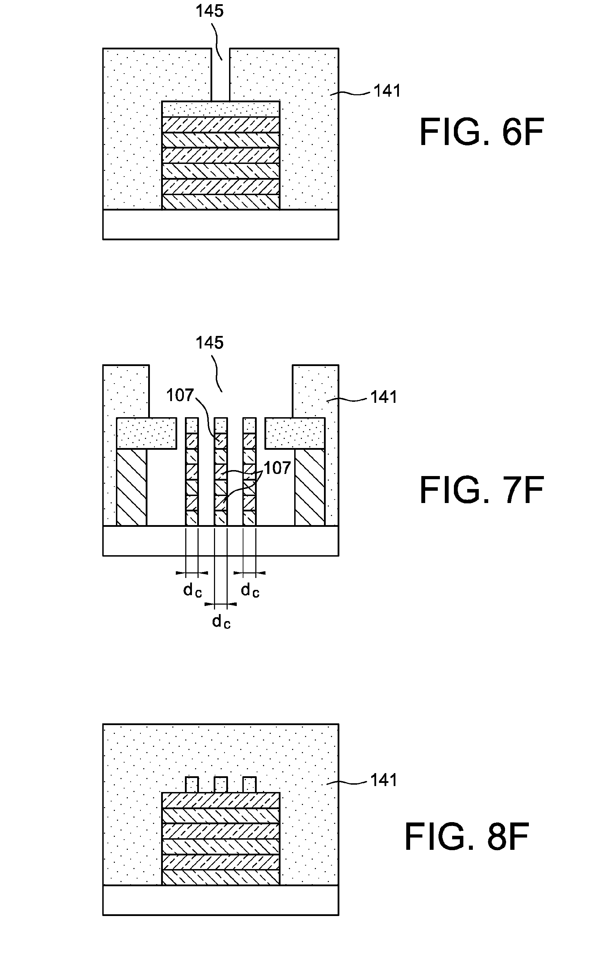

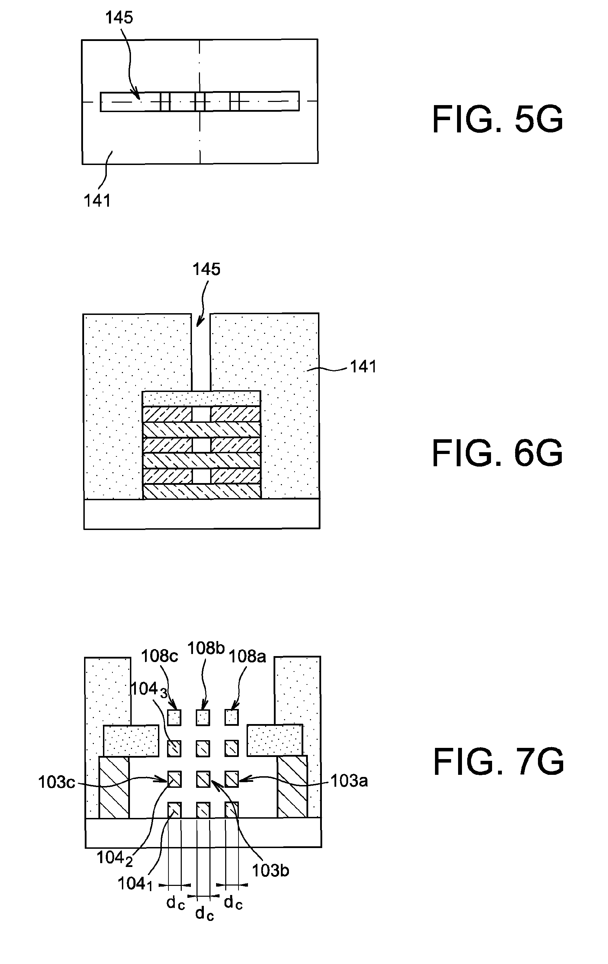

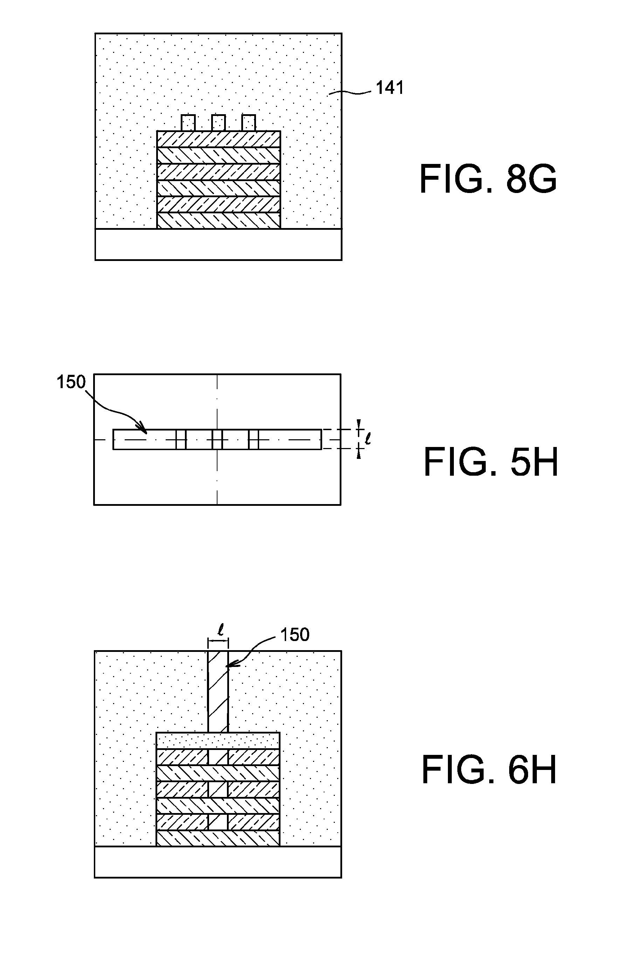

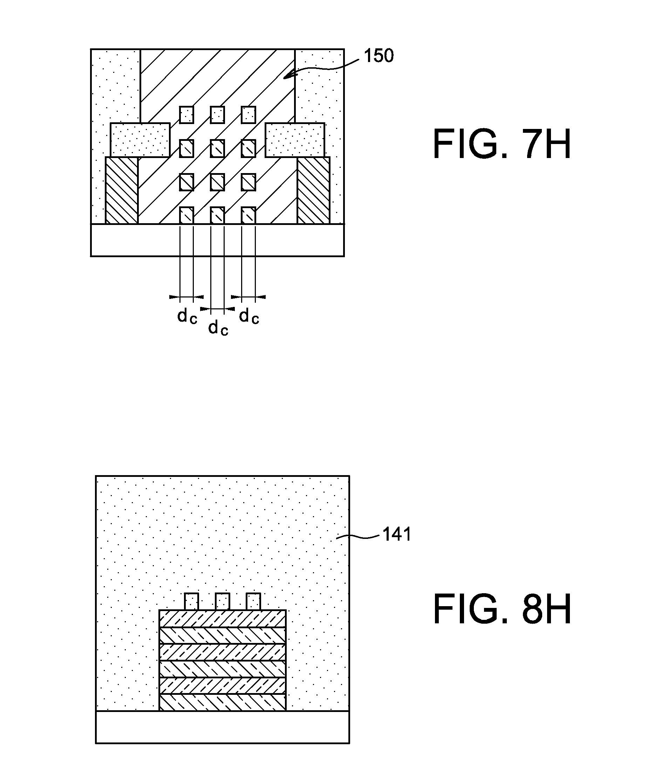

Un exemple de procédé de réalisation d'un dispositif microélectronique comprenant un transistor doté d'une structure semi-conductrice formée d'une pluralité de nano-fils, va à présent décrit en liaison avec les figures 4A-4F (représentant une portion de la structure semi-conductrice en cours de réalisation selon une vue en perspective), les figures 5A-5H (représentant la structure semi-conductrice en cours de réalisation selon une vue de dessus), les figures 6A-6H (représentant la structure semi-conductrice en cours de réalisation selon une vue en coupe transversale B'B indiquée sur les figures de 5A-5H), les figures 7A-7H (représentant la structure semi-conductrice selon une vue en coupe transversale A'A indiquée sur les figures de 5A-5H), les figures 8B-8H (représentant la structure semi-conductrice selon une vue en coupe C'C indiquée sur les figures de 5B-5H).

Le matériau de départ du procédé peut être un support 100 tel qu'un substrat de type communément appelé « bulk » formé d'une couche de support conductrice, ou tel qu'un substrat de type semi-conducteur sur isolant, par exemple de type SOI (« SOI pour « Silicon On Insulator » ou silicum sur isolant) ou de sSOI (sSOI pour « strained SOI » ou SOI contraint) formé d'une couche semi conductrice par exemple à base de Si recouverte d'une couche isolante par exemple à base SiO₂, elle-même recouverte d'une fine couche semi-conductrice.

On forme tout d'abord sur ce support 100 plusieurs empilements 103a, 103b, 103c de barreaux, encore appelés nano-fils semi-conducteurs (un seul empilement 103a étant illustré sur la figure 4A, et sur les figures 4B-4F suivantes). Ces empilements 103a, 103b, 103c peuvent être formés chacun d'une alternance de barreaux ou de nanofils 104₁, 104₂, 104₃, à base d'un premier matériau semi-conducteur 105 tel que par exemple du silicium et de barreaux ou nano-fils 106₁, 106₂, 106₃, à base d'un deuxième matériau semi-conducteur 107 tel que par exemple du SiₓGe_{y}. Le deuxième matériau semi-conducteur 107 peut avoir une teneur en germanium comprise par exemple entre 10 et 100%, de préférence entre 15 % et 50 % afin de permettre une bonne sélectivité de gravure entre le premier matériau semi-conducteur 105 et le deuxième matériau semi-conducteur 107.

Selon une possibilité de mise en oeuvre, le premier matériau semi-conducteur 105 peut être contraint par exemple du silicium contraint en tension, tandis que le deuxième matériau semi-conducteur 107 peut être contraint par exemple du SiₓGe_{y} contraint en compression.

Pour réaliser les empilements de nano-fils, on peut réaliser tout d'abord un empilement de couches semi-conductrices, formé par exemple par épitaxie, d'une alternance de couches à base du premier matériau semi-conducteur 105 et de couches à base du deuxième matériau semi-conducteur 107.

On grave ensuite l'empilement de couches à travers un masquage, qui peut être un masque dur 108 à base par exemple de nitrure de silicium tel que du Si₃N₄.

Dans cet exemple (figures 5A et 7A), le masque dur 108 est formé de plusieurs blocs 108a, 108b, 108c, ayant une section transversale constante (la section transversale étant définie comme une section prise dans un plan parallèle au plan [o; *̅i̅*̅ ; *̅k̅*̅ ] du repère orthogonal [o; *̅i̅*̅ ; *̅j̅*̅ ; *̅k̅*̅ ] sur les figures 4A à 7A).

A travers les blocs 108a, 108b, 108c, qui peuvent être de forme parallélépipédique, on réalise une gravure, qui peut être anisotrope, de l'empilement de couches semi conductrices, de sorte que les nano-fils des empilements 103a, 103b, 103c, reproduisent la forme des blocs 108a, 108b, 108c, et ont également une section transversale constante.

Ainsi, chaque empilement 103a, 103b, 103c, est doté d'extrémités ayant une section transversale sensiblement égale ou égale à celle de son centre.

Les nano-fils 104₁, 106₁, 104₂, 106₂, 104₃, 106₃, obtenus à l'issue de cette gravure peuvent ainsi avoir une forme parallélépipédique. Les nano-fils 104₁, 106₁, 104₂, 106₂, 104₃, 106₃, peuvent également avoir une dimension critique dc, comprise par exemple entre 5 nanomètres et 25 nanomètres.

Par « dimension critique », on entend tout au long de la description, la plus petite dimension d'un motif hormis son épaisseur, la dimension critique étant mesurée dans une direction parallèle au plan principal du support (le plan principal du support, étant défini sur les figures 4A et 7A comme un plan parallèle au plan [o; *̅i̅*̅ ; *̅j̅*̅] d'un repère orthogonal [o; *̅i̅*̅ ; *̅j̅*̅ ; *̅k̅*̅ ]).

Les nano-fils 104₁, 106₁, 104₂, 106₂, 104₃, 106₃, peuvent avoir une épaisseur e, comprise par exemple entre 2 nanomètre et 50 nanomètre (mesurée dans une direction parallèle au vecteur *̅k̅*̅ du repère orthogonal [o; *̅i̅*̅ ; *̅j̅*̅ ; *k̅* ] sur la figure 4A).

Les nano-fils 104₁, 106₁, 104₂, 106₂, 104₃, 106₃, peuvent également avoir une longueur, comprise par exemple entre 20 nanomètre et 150 nanomètre (mesurée dans une direction parallèle au vecteur *̅j̅*̅ du repère orthogonal [O; *̅i̅*̅ ; *̅j̅*̅ ; *̅k̅*̅ ] sur la figure 4A) en particulier pour une longueur de grille prévue entre 10 et 100nm. La longueur totale des nano-fils est de préférence supérieure à une longueur minimale correspondant à la longueur cumulée de grille et 2 fois la longueur des contacts.

On forme ensuite (figures 4B, 5B, 6B, 7B, 8B) sur une région centrale des empilements de nano-fils, un diélectrique de grille, par exemple un oxyde de grille tel que du TEOS recouvert d'au moins une couche de matériau de grille par exemple tel que du polysilicum.

L'empilement de grille ainsi réalisé sur une région centrale des empilements 103a, 103b, 103c, de nano-fils, recouvre le dessus et les flancs latéraux de cette région centrale des empilements 103a, 103b, 103c.

Ainsi, l'empilement de grille peut avoir une hauteur (mesurée dans une direction orthogonale au support 100 et parallèle au vecteur *̅k̅*̅ du repère orthogonal [o; *̅i̅*̅ ; *̅j̅*̅ ; *̅k̅*̅ ] sur les figures 4B, 6B, 8B), supérieure à celle des empilements 103a, 103b, 103c de nano-fils.

On grave ensuite cet empilement de grille à travers un masquage, qui peut être un masque dur 118 ayant une forme de grille factice, de manière à former une grille sacrificielle 110 recouvrant le dessus et les flancs latéraux d'une zone centrale des empilements 103a, 103b, 103c.

Le masque dur 118 peut avoir une épaisseur comprise, par exemple, entre 10 nm et 100 nm et peut-être, par exemple, à base de nitrure de silicium tel que du Si₃N₄.

La grille sacrificielle 110 peut être formée avec une longueur L (mesurée dans une direction parallèle au vecteur *j̅* du repère orthogonal [o; *i̅* ; *j̅* ; *k̅* ] sur les figures 4B et 6B) comprise par exemple entre 10 nm et 150 nm. La longueur L de la grille sacrificielle 110 peut correspondre à la dimension critique du masque dur 118.

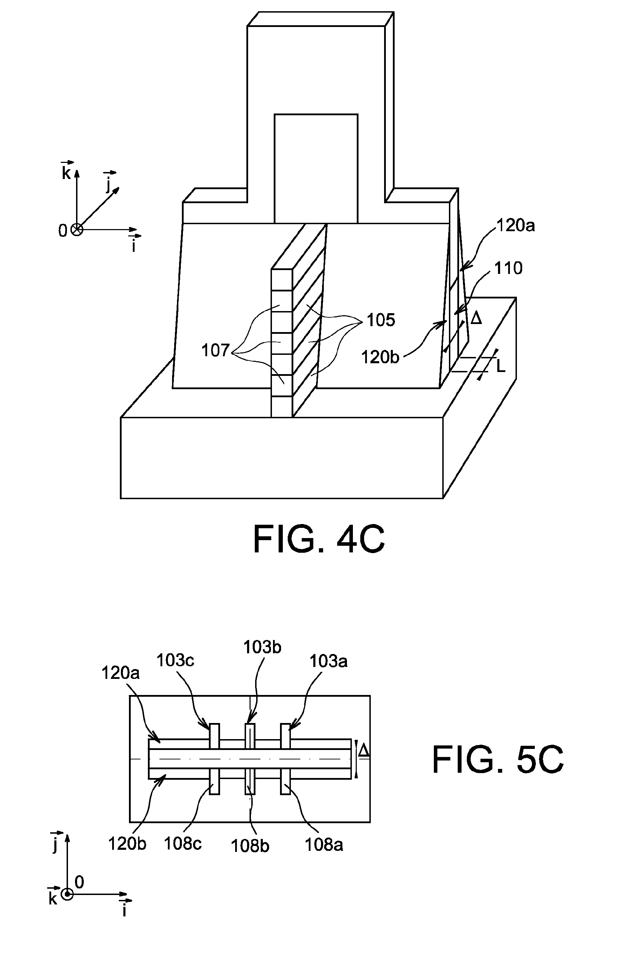

On forme ensuite (Figures 4C, 5C, 6C, 7C, 8C) des zone isolantes 120a, 120b encore appelées espaceurs contre la grille sacrificielle 110 et le masque dur 118, de part et d'autre de chacun des empilements 103a, 103b, 103c de barreaux semi-conducteurs.

Les zones isolantes 120a, 120b sont espacées entre elles d'une distance Δ correspondant à la longueur L de grille sacrificielle 110 (L et Δ étant mesurées dans une direction parallèle au vecteur *̅j̅*̅ du repère orthogonal [o; *̅i̅*̅ ; *̅j̅*̅ ; *̅k̅*̅ ] sur les figures 4C et 5C).

Les zones isolantes 120a, 120b et la grille sacrificielle 110 sont ainsi réalisées de sorte à couvrir et masquer une zone centrale de chaque empilement 103a, 103b, 103c, de nano-fils semi-conducteurs, ces nano-fils ayant des extrémités libres, qui ne sont pas recouvertes d'un autre matériau. Les extrémités des nano-fils ne sont en particulier recouvertes ni par les zones isolantes 120a, 120b, ni par les masques durs 108, 118, ou la grille sacrificielle 110.

Les zones isolantes 120a, 120b, peuvent être réalisées par dépôt d'une couche isolante, par exemple à base de nitrure de silicium ou d'un empilement de couches formé d'une couche d'oxyde de silicium et d'une couche de nitrure de silicium sur le support 100, jusqu'au niveau du masque dur 108 puis par gravure de cette couche isolante.

Ensuite, on forme aux extrémités des empilements 103a, 103b, 103c, des zones de source 137 et de drain 139.

Cela peut être réalisé par croissance de matériau semi-conducteur au niveau des zones libres des nano-fils c'est-à-dire au niveau des zones des empilements 103a, 103b, 103c qui sont dévoilées et ne sont pas recouvertes par le masque dur 108 ou par les zones isolantes 120a, 120b, ou par la grille sacrificielle 110 surmontée du masque dur 118 (figures 4D, 5D, 6D, 7D, 8D).

Ainsi, selon une possibilité de mise en oeuvre, on peut réaliser une croissance du premier matériau semi-conducteur 105 aux extrémités des nano-fils 104₁, 104₂, 104₃ à base du premier matériau semi-conducteur 105 et/ou une croissance du deuxième matériau semi-conducteur 107 aux extrémités des nano-fils 106₁, 106₂, 106₃ à base du deuxième matériau semi-conducteur 107.

A l'issue de cette étape, les nano-fils 104₁, 104₂, 104₃, 106₁, 106₂, 106₃ des empilements 103a, 103b, 103c, ont des extrémités libres plus larges qu'au niveau de leur portion centrale recouverte par la grille sacrificielle 110 et par les zones isolantes 120a, 120b. A l'issue de cette étape, les nano-fils conservent leur dimension critique dc.

La croissance peut être réalisée de sorte que l'épaisseur E (mesurée dans une direction parallèle au support 100 et au plan [o; *̅i̅*̅ ; *̅j̅*̅] du repère orthogonal [o; *̅i̅*̅ ; *̅j̅*̅ ; *̅k̅*̅ ] sur la figure 4D) de matériau conducteur formé par croissance sur les nano-fils peut être comprise par exemple entre 10 nm et 50 nm.

Par croissance de matériau semi-conducteur au niveau des extrémités libres des nano-fils, on réalise un ajustement des dimensions des zones de source et de drain.

Un profil dentelé peut être mis en oeuvre sur les zones de source et de drain.

Ce profil dentelé peut être obtenu en utilisant, lors de la croissance un gaz susceptible de graver sélectivement le deuxième matériau semi-conducteur vis-à-vis du premier matériau semi-conducteur.

Ce gaz peut être par exemple du HCl, en particulier dans le cas où le deuxième matériau semi-conducteur est du SiGe.

Pour obtenir des profils dentelés différents, on peut moduler la teneur en HCl.

Avec un précurseur à base de silane pour une croissance de Si ou un précurseur à base de dichloro-silane et germane pour une croissance de SiGe.

Un dopage des zones de source 137 et de drain 139 peut-être également effectué. Ce dopage peut être réalisé après croissance, par exemple par implantation ionique à base de Bore dans le cas où l'on souhaite réaliser un transistor de type PMOS, ou à base de phosphore ou d'arsenic dans le cas où l'on souhaite réaliser un transistor de type NMOS.

Selon une autre possibilité, le dopage peut être réalisé *in-situ* au moment de la croissance par épitaxie des zones de source et de drain par incorporation de Bore ou de Phosphore par exemple.

Ensuite, on forme sur le support une couche de masquage 141 de manière à recouvrir la structure et le deuxième masque dur 118.

La couche de masquage 141 peut être choisie à base d'un matériau susceptible d'être gravé de manière sélective vis-à-vis de celui du deuxième masque dur 118. Cette couche de masquage 141 peut-être à base d'un oxyde de silicium tel que ceux communément appelé PMD (« PMD » pour « Pre Metal Dielectric ») utilisés généralement avant des étapes de réalisation d'éléments métalliques.

Une étape de retrait, par exemple par aplanissement ou polissage CMP (CMP pour « Chemical Mechanical Planarization »), de cette couche de masquage 141 est ensuite réalisée avec un arrêt au niveau du sommet du deuxième masque dur 118. La face supérieure ou le dessus du masque dur 118 est ainsi dévoilé(e) à l'issue de cette étape de retrait (figures 4E, 5E, 6E, 7E 8E). Cela peut permettre ultérieurement d'effectuer un retrait de ce masque dur 118 sans avoir à réaliser une étape de photolithographie nécessitant un alignement.

Puis, on réalise dans la couche de masquage 141, une ouverture 145 dont le fond dévoile le support, de manière à dévoiler à nouveau la portion centrale des empilements 103a, 103b, 103c. Cette ouverture 145 est tout d'abord réalisée par retrait du deuxième masque dur 118 recouvrant les empilements 103a, 103b, 103c.

Le deuxième masque dur 118 peut être gravé de manière sélective par rapport au matériau de la couche de masquage 141 à l'aide, par exemple, d'une gravure chimique à base de TMAH (Tetramethylammonium hydroxide).

L'ouverture 145 réalisée peut avoir une section constante. L'ouverture 145 réalisée dans la couche de masquage, permet de conserver l'empreinte exacte de la grille sacrificielle 110.

L'ouverture 145 formée dans la couche de masquage 141 peut avoir une disposition et des dimensions prévues en fonction de celles des zones isolantes 120a, 120b. L'ouverture 145 peut ainsi avoir une dimension critique Dc égale ou sensiblement égale à la longueur L de la grille sacrificielle 110 (la dimension critique Dc étant mesurée dans une direction parallèle au vecteur *j̅* du repère orthogonal [o; *i̅* ; *j̅* ; *k̅* ] sur les figures 1F et 2F).

On prolonge ensuite l'ouverture 145, en retirant également des portions de la grille sacrificielle 110 situées au dessus des empilements 103a, 103b, 103c de nanofils et contre les flancs latéraux des nano-fils dans la région centrale des empilements 103a, 103b, 103c.

Le retrait la grille sacrificielle 110 peut être réalisé par exemple par une gravure humide à l'aide d'une solution de TMAH (Tétraméthylammonium hydroxide), avec arrêt sur le diélectrique de grille sacrificielle (figures 4F, 5F, 6F, 7F 8F) qui est ensuite retiré dans l'ouverture 145.

Puis, (figures 5G, 6G, 7G, 8G) on effectue dans l'ouverture 145, un retrait de l'un des matériaux semi-conducteurs 105, 107 sélectif vis-à-vis de l'autre matériau semi-conducteur.

Par exemple, un retrait du deuxième matériau semi-conducteur 107 sélectivement par rapport au premier matériau semi-conducteur 105 peut être réalisé, en particulier si l'on souhaite réaliser un transistor de type NMOS. Ce retrait sélectif peut être effectué, par exemple par gravure chimique en phase vapeur, par exemple à l'aide d'Hcl mélangé à un gaz porteur ou par gravure chimique à base de CF₄, dans le cas où le matériau retiré est du SiₓGe_{y}.

On obtient ainsi dans l'ouverture 145, des nano-fils suspendus à base du premier matériau semi-conducteur 105. Les nano-fils 104₁, 104₂, 104₃ à base du premier matériau semi-conducteur 105 peuvent ainsi avoir une portion centrale détourée, autrement dit qui n'est pas recouverte d'un autre matériau. Le deuxième matériau semi-conducteur 107 est conservé à l'extrémité des nano-fils 104₁, 104₂, 104₃, 106₁, 106₂, 106₃, hors de l'ouverture 145. A l'issue de cette gravure, les nano-fils 104₁, 104₂, 104₃ à base du premier matériau semi-conducteur 105 conservent une dimension critique dc.

À travers cette ouverture 145, on peut ensuite former une grille.

Un empilement de grille peut être réalisé de manière conforme, par exemple à l'aide d'un dépôt par CVD (CVD pour « Chemical Vapor Deposition »), d'un diélectrique de grille par exemple à base de HfO₂, ou de HfSiON, et d'au moins un matériau de grille, par exemple formé d'une couche de métal tel que du TiN ou du TaN et d'une couche de matériau semi-conducteur tel que du polysilicium, de manière à remplir l'ouverture 145.

Une grille enrobante 150 autour d'une portion centrale des nano-fils 104₁, 104₂, 104₃ de dimension critique dc est ainsi formée (figures 5H, 6H, 7H, 8H).

Ainsi, la grille 150 est formée autour d'une portion centrale des nano-fils 104₁, 104₂, 104₃ dont la dimension critique dc est la même qu'après la réalisation des empilements décrits précédemment en liaison avec les figures 4A, 5A, 6A, 7A.

Une étape de retrait du matériau de grille dépassant au dessus de l'ouverture 145 peut-être ensuite réalisée.

A l'issue de cette étape, une grille ayant une longueur de grille I (mesurée dans une direction parallèle au vecteur *̅j̅*̅ du repère orthogonal [o; *̅i̅*̅ ; *̅j̅*̅ ; *̅k̅*̅ ] sur les figures 5H et 8H) définie par la dimension critique Dc de l'ouverture 145 est réalisée. La grille 150 peut avoir une longueur I constante sensiblement égale à la distance Δ séparant les zones isolantes 120a, 120b entre elles et à la longueur L de la grille sacrificielle 110 qui a été préalablement retirée peut être ainsi obtenue.

Ainsi, dans le procédé qui vient d'être décrit, après avoir réalisé les empilements de nano-fils (figures 4A, 5A, 6A, 7A), une étape de réduction des dimensions de ces derniers n'est pas nécessaire avec le procédé suivant l'invention.

On peut prévoir, afin de limiter l'encombrement de la structure de transistor en réalisant des empilements de nano-fils de dimension critique dc faible et qu'il n'est pas nécessaire de graver à nouveau ultérieurement pour réduire cette dimension critique dc.

Les extrémités des empilements étant protégées durant l'étape de retrait sélectif du deuxième matériau semi-conducteur 107 décrite en liaison avec les figures 4F-4G, 5F-5G, 6F-6G, 7F-7G, le fait d'avoir prévu des empilements de nano-fils de dimension critique dc, ne pose pas de problème de stabilité de la structure.

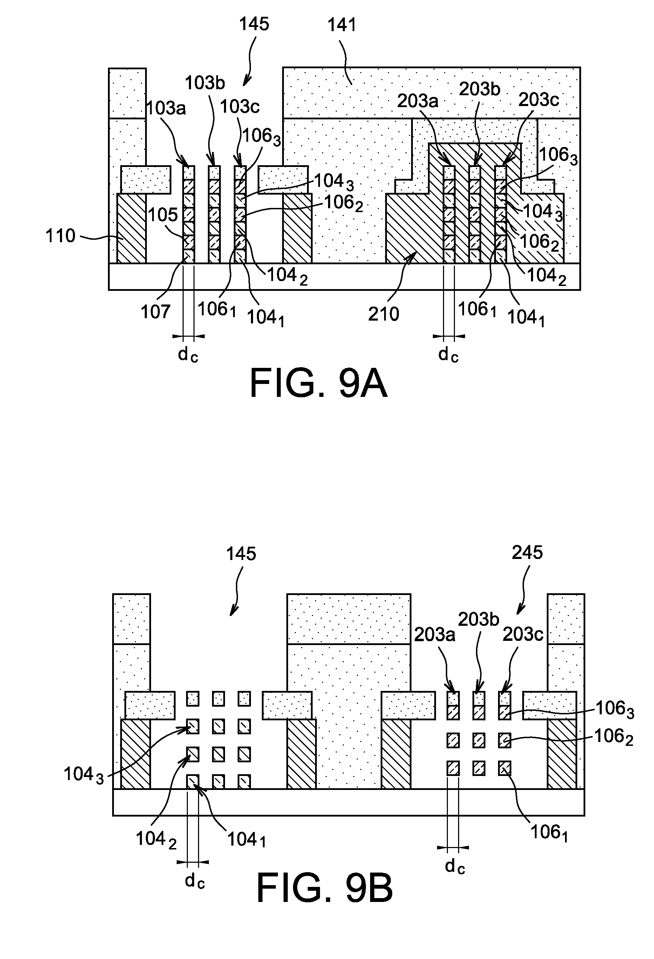

Une variante de l'exemple de procédé de réalisation décrit précédemment et permettant de former des transistors à nano-fils de type PMOS et des transistors à nano-fils de type NMOS sur le même support 100 va à présent être donné en liaison avec les figures 9A-9B.

Dans cet exemple, un premier ensemble de plusieurs empilements 103a, 103b, 103c de nano-fils semi-conducteurs et un deuxième ensemble de plusieurs empilements 203a, 203b, 203c, de nano-fils semi-conducteurs sont formés sur un support 100. Les empilements 103a, 103b, 103c, 203a, 203b, 203c ont chacun une section transversale constante avec des nanofils de dimension critique dc.

Les empilements 103a, 103b, 103c, 203a, 203b, 203c, sont formés chacun d'une alternance de nano-fils 104₁, 104₂, 104₃, à base d'un premier matériau semi-conducteur 105 tel que par exemple du Si et de nano-fils 106₁, 106₂, 106₃, à base du deuxième matériau semi-conducteur 107 tel que par exemple du SiₓGe_{y}, par gravure de couches semi-conductrices à travers des masques durs (non représentés).

Après avoir réalisé des étapes de formation des grilles sacrificielle 110, 210 sur chaque ensemble d'empilements 103a, 103b, 103c, et 203a, 203b, 203c, de nano-fils et des zones isolantes d'espacement (non représentées) de part et d'autre des grilles sacrificielles 110, 210, on forme la couche de masquage 141 recouvrant les empilements 103a, 103b, 103c, et 203a, 203b, 203c et les grilles sacrificielles.

La couche de masquage 141 peut être ensuite aplanie jusqu'à dévoiler les masques dur recouvrant respectivement les grilles sacrificielles 110 et 210.

Puis, une première ouverture 145 est formée dans la couche de masquage 141 (figure 9A), de manière à dévoiler une région centrale du premier ensemble d'empilements 103a, 103b, 103c, de nano-fils.

On peut pour cela définir un masque dur 243 au dessus des empilements 203a, 203b, 203c, qui permet de protéger la grille sacrificielle au dessus de ces zones. Ce masque dur 243 peut être, par exemple, en polysilicium ou en nitrure de silicium ou en oxyde de silicium et d'épaisseur comprise par exemple entre 3 et 10 nm.

On effectue ensuite un retrait sélectif du deuxième matériau semi-conducteur 107 vis-à-vis du premier matériau semi-conducteur 105. Ce retrait sélectif peut être par exemple réalisé à l'aide d'Hcl mélangé à un gaz porteur ou par gravure chimique à base de CF₄.

On obtient ainsi dans la première ouverture 145 des nano-fils suspendus à base du premier matériau semi-conducteur 105, par exemple à base de silicium.

Après avoir retiré le masque dur, on forme ensuite une deuxième ouverture 245 dans la couche de masquage 141, de manière à dévoiler une région centrale du deuxième ensemble d'empilements 203a, 203b, 203c. La première ouverture 145 peut, quant à elle, être comblée au moins partiellement à l'aide d'un masque de protection des empilements 103a, 103b, 103c.

Ce masque de protection peut être réalisé par exemple à l'aide d'un matériau susceptible d'être gravé de manière sélective vis-à-vis de celui de la couche de masquage 141, par exemple un matériau tel que du Si₃N₄ utilisé pour former le ou les masque(s) dur(s).

On effectue ensuite un retrait sélectif du premier matériau semi-conducteur 105 vis-à-vis du deuxième matériau semi-conducteur 107 dans la deuxième ouverture 245.

On obtient ainsi dans l'ouverture 245 des nano-fils suspendus à base du deuxième matériau semi-conducteur 107. Les nano-fils suspendus à base du deuxième matériau semi-conducteur 107 conservent la même dimension critique dc qu'une fois avoir réalisé les empilements.

Puis, on retire le masque de protection dans la première ouverture 145 (figure 9B).

On peut ensuite réaliser une grille dans les ouvertures 145, 245, de manière à entourer les nano-fils de dimension critique dc.

Selon un autre mode de réalisation, après avoir effectué le retrait sélectif du deuxième matériau semi-conducteur 107 vis-à-vis du premier matériau semi-conducteur 105 dans l'ouverture 145, on dépose un empilement de grille dans cette ouverture 145.

On effectue ensuite un retrait sélectif du premier matériau semi-conducteur 105 vis-à-vis du deuxième matériau semi-conducteur 107 dans une deuxième ouverture 245 réalisée dans la couche de masquage 141, de manière à dévoiler une région centrale du deuxième ensemble d'empilements 203a, 203b, 203c.

Avec un tel mode de réalisation, et par rapport au mode de réalisation précédent, on peut prévoir des transistors de type PMOS avec un empilement de grille donné adapté au type PMOS et des transistors à nano-fils de type NMOS avec un empilement de grille différent, adapté au type NMOS.

## Revendications

1. Procédé de réalisation d'un dispositif microélectronique comprenant un transistor doté d'une structure semi-conductrice formée de nano-fils, le procédé comprenant les étapes de :
a) réalisation sur un support (100), d'un empilement ou de plusieurs empilements juxtaposés (103a, 103b, 103c, 203a, 203b, 203c) de nano-fils, le ou les empilements ayant une section transversale constante et étant formés d'une alternance de nano-fils (104₁, 104₂, 104₃) à base d'au moins un premier matériau semi-conducteur (105), et de nano-fils (106₁, 106₂, 106₃) à base d'au moins un deuxième matériau semi-conducteur (107),
b) formation d'une grille sacrificielle (110) sur, et contre des flancs latéraux de, au moins une zone centrale d'au moins un ou plusieurs desdits empilements (103a, 103b, 103c) de section transversale constante,
c) formation de zones isolantes (120a, 120b) contre des flancs latéraux de ladite grille sacrificielle, de manière à couvrir des zones desdits flancs latéraux desdits empilements (103a, 103b, 103c) de part et d'autre de ladite zone centrale desdits empilements,
d) formation de zones semi-conductrices (137, 139) sur des zones d'extrémités d'au moins un desdits empilement (103a, 103b, 103c) par croissance d'au moins un matériau semi-conducteur.

2. Procédé selon la revendication 1, dans lequel la formation à l'étape a) des empilements (103a, 103b, 103c) de nano-fils comprend la gravure, à travers un masque dur (108), d'un empilement de couches formé d'une alternance de couches à base du premier matériau semi-conducteur (105) et de couches à base du deuxième matériau semi-conducteur (107), le ou les empilements (103a, 103b, 103c) de nano-fils étant recouverts dudit masque dur (108) à l'étape d).

3. Procédé selon l'une des revendication 1 ou 2, dans lequel la formation à l'étape a) des empilements (103a, 103b, 103c) de nano-fils comprend la gravure anisotrope, à travers un masque dur (108), d'un empilement de couches formé d'une alternance de couches à base du premier matériau semi-conducteur (105) et de couches à base du deuxième matériau semi-conducteur (107), le masque dur étant formé d'une ou plusieurs zones de section transversale constante.

4. Procédé selon l'une des revendications 1 à 3, comprenant en outre après l'étape d), des étapes de :
- formation sur ledit support d'une couche de masquage (141) recouvrant ledit ou lesdits empilements (103a, 103b, 103c) et la grille sacrificielle (110),
- formation d'une ouverture (145) dans la couche de masquage (141) comprenant la gravure de la grille sacrificielle (110) de manière à dévoiler ladite zone centrale dudit ou desdits empilements de nano-fils.

5. Procédé selon la revendication 4, ladite ouverture ayant une dimension critique (Dc) égale ou sensiblement égale à la longueur (L) de la grille sacrificielle (110).

6. Procédé selon la revendication 4 ou 5, dans lequel la grille sacrificielle (110) est formée à l'étape b) par gravure d'un empilement de grille au travers d'un autre masque dur (118), la formation de ladite ouverture (145) dans la couche de masquage (141) comprenant la gravure sélective dudit autre masque dur (118) préalablement à la gravure de la grille sacrificielle (110).

7. Procédé selon l'une des revendications 5 ou 6, comprenant en outre, après formation de la couche de masquage (141) et préalablement à la formation de ladite ouverture (145), une étape de retrait de la couche de masquage jusqu'à atteindre ledit autre masque dur (118).

8. Procédé selon l'une des revendications 4 à 7, comprenant en outre, le retrait sélectif dans ladite ouverture (145) du deuxième matériau semi-conducteur (107) vis-à-vis du premier matériau semi-conducteur (105).

9. Procédé selon la revendication 8, comprenant en outre, après le retrait sélectif du deuxième matériau semi-conducteur, la formation d'une grille dans ladite ouverture (145).

10. Procédé selon la revendication 9, dans lequel l'étape b) comprend la formation d'une grille sacrificielle (110) sur un ou plusieurs empilements parmi les desdits empilements, et la formation d'une autre grille sacrificielle (210) sur un ou plusieurs autres empilements parmi lesdits autres empilements, et dans lequel une autre ouverture (245) est réalisée dans ladite couche de masquage (141) recouvrant lesdits empilements (103a, 103b, 103c), le procédé comprenant en outre le retrait de ladite autre grille sacrificielle (210) à travers ladite autre ouverture (245), puis le retrait sélectif du premier matériau semi-conducteur (105) vis-à-vis du deuxième matériau semi-conducteur (107) dans la dite autre ouverture (245).

11. Procédé selon la revendication 9 dans lequel à l'issue de l'étape a) et préalablement à l'étape b), les nano-fils ont une dimension critique dc donnée, la grille étant formée dans ladite ouverture (145) sur et autour de nanofils de dimension critique dc donnée.
